# EUROPEAN PATENT APPLICATION

(11) **EP 2 261 388 A1**
(43) Date of publication of application: **15.12.2010**
(21) Application number: 09162626.7
(22) Date of filing: 12.06.2009
(51) Int. Cl.: C23C 14/54, C23C 14/12, G01B 7/06

(54) **Deposition rate monitor device, evaporator, coating installation, method for applying vapor to a substrate and method of operating a deposition rate monitor device**

(71) Applicant: Applied Materials Inc. a Corporation of the State of Delaware, 3050 Bowers Avenue Santa Clara, California 95054 (US)
(72) Inventor: Dieguez-Campo, Manuel, 63457 Hanau (DE); Sommer, Elisabeth, 63755 Alzenau (DE); Ries, Florian, 63825 Westerngrund (DE); Mattern, Frank, 63452 Hanau (DE)
(74) Representative: Zimmermann & Partner

(57) **Abstract**

A deposition rate monitor device for monitoring the deposition rate of a vapor on a substrate is provided, including: a piezoelectric crystal monitor device (101) including a piezoelectric crystal monitor provided in a housing (102), wherein the housing includes a vapor inlet aperture (107), and at least one elongated shielding device (106) having a first end (108) and a second end (109), the first end encompassing the vapor inlet aperture.

## Description

### TECHNICAL FIELD OF THE INVENTION

Embodiments relate to a deposition rate monitor device, an evaporator, a coating installation, a method for applying vapor to a substrate and a method of operating a deposition rate monitor device. Embodiments particularly relate to an evaporator with a measurement means for measuring the deposition rate of the evaporator, a coating installation having such an evaporator and a method for applying vapor to a substrate.

### BACKGROUND OF THE INVENTION

Evaporators are needed in various technical fields. For instance, organic evaporators are an essential tool for certain production types of organic light-emitting diodes (OLED). OLEDs are a special type of light-emitting diodes in which the emissive layer includes a thin-film of certain organic compounds. Such systems can be used in television screens, computer displays, portable system screens, and so on. OLEDs can also be used for general space illumination. The range of colours, brightness, and viewing angle possible with OLED displays are greater than that of traditional LCD displays because OLED pixels directly emit light and do not require a back light. Therefore, the energy consumption of OLED display is considerably less than that of traditional LCD displays. Further, the fact that OLEDs can be printed onto flexible substrates opens the door to new applications such as roll-up displays or even displays embedded in clothing.

The performance of products manufactured using evaporators is often influenced by the thickness of evaporated layers. For instance, the functionality of an OLED depends on the coating thickness of the organic material. This thickness has to be within a predetermined range. In the production of OLEDs it is therefore important, that the coating rate, at which the coating with organic material is effected, lies within a predetermined tolerance range.

In other words, the coating rate, also called deposition rate, of evaporators, such as an organic evaporator, has to be controlled thoroughly in the coating process, e.g. by feedback control.

In order to do so, it is known in the art to use so called piezoelectric microbalances, such as quartz crystal micro balances, also referred to as quartz monitors or quartz resonators, for the determination of the coating rate. The measurement of the actual oscillating frequency of these oscillating piezoelectric crystals allows the conclusion on the actual coating rate. However, in deposition systems, such as an inline deposition system, the signal from the piezoelectric crystal may be affected by the influence of the chamber pressure, by temperature and, in case of an inline deposition, by the moving substrate carrier.

### SUMMARY

In light of the above, it is provided a deposition rate monitor device according to claim 1, an evaporator according to claim 8, a coating installation according to claim 11, a method for applying vapor to a substrate according to claim 14 and a use according to claim 16.

According to one embodiment, a deposition rate monitor device for monitoring the deposition rate of a vapor on a substrate is provided, including: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture

In a further embodiment an evaporator for applying vapor to a substrate at a deposition rate is provided. The evaporator includes: an evaporator tube having a vapor source and a distribution pipe with at least one nozzle outlet, and a deposition rate monitor device which includes: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture.

According to another embodiment, a coating installation for coating a substrate is provided. The coating installation includes at least one element selected from the group consisting of: a deposition rate monitor device including: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture; an evaporator including: an evaporator tube having a vapor source and a distribution pipe with at least one nozzle outlet, and a deposition rate monitor device which includes: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture; a control device adapted for controlling the vapor source depending on the deposition rate; and a control device adapted for controlling at least one element selected from the group consisting of the evaporator, the deposition rate monitor device, and the vapor source.

According to one embodiment, a coating installation for coating a substrate is provided, including a coating chamber having an evaporator including a deposition rate monitor device with a piezoelectric crystal monitor device, the piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture; and a locking device adapted for separating the coating chamber and the deposition rate monitor device.

According to a further embodiment, a method for applying vapor to a substrate is provided with the steps of providing the vapor using at least one element selected from the group consisting of: a deposition rate monitor device including: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture; an evaporator including: an evaporator tube having a vapor source and a distribution pipe with at least one nozzle outlet, and a deposition rate monitor device which includes: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture; and a coating installation including at least one element selected from the group consisting of: the deposition rate monitor device; the evaporator; a control device adapted for controlling the evaporator depending on the deposition rate; and a control device adapted for controlling at least one element selected from the group consisting of the evaporator and the deposition rate monitor device; determining the deposition rate of the vapor, and applying the vapor to the substrate.

In one embodiment, a method of operating a deposition rate monitor device is provided, the deposition rate monitor device including: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture, the method being performed in at least one process selected from the group consisting of coating a substrate, evaporation, sputtering, CVD and PVD.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. They may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of embodiments can be understood in detail, a more particular description of embodiments of the invention, briefly summarized above, may be had by reference to examples of embodiments. The accompanying drawings relate to embodiments of the invention and are described in the following. Some of the above mentioned embodiments will be described in more detail in the following description of typical embodiments with reference to the following drawings in which:

Figs. 1A and 1B schematically show embodiments of a deposition rate monitor device;

Figs. 2A and 2B schematically show an embodiment of an evaporator, Fig. 2A illustrating a front view on a distribution pipe of the evaporator and Fig. 2B illustrating a side view of the evaporator;

Fig. 3 schematically illustrates other embodiments of the evaporator;

Fig. 4 shows schematically a cross sectional side view of embodiments of a coating installation;

Fig. 5A and 5B schematically show embodiments of a deposition rate monitor device, the deposition rate monitor device of Fig. 5B being provided at an evaporator; and

Fig. 6A and 6B schematically show embodiments of a deposition rate monitor device provided at an evaporator.

It is contemplated that elements of one embodiment may be advantageously utilized in other embodiments without further recitation.

### DETAILLED DESCRIPTION OF EMBODIMENTS

Reference will now be made in detail to the various embodiments, one ore more examples of which are illustrated in the figures. Each example is provided by way of explanation, and is not meant as a limitation of the invention.

Without limiting the scope, in the following the examples and embodiments are described referring to a deposition rate monitor device used in a vacuum deposition of organic coatings and to an evaporator for applying organic vapor, also called herein organic evaporator, the evaporator including a deposition rate monitor device according to embodiments. Typically, embodiments described herein may include vacuum-compatible materials and a coating installation of embodiments may be a vacuum coating installation. Typical applications of embodiments described herein are for example deposition applications, e.g. deposition of organic coatings, in the production of displays such as LCD, TFT displays and OLED (Organic Light Emitting Diode), in solar wafer manufacturing and in semiconductor device production. The deposition rate monitor device according to embodiments can also be applied to other coating devices and other coating procedures. For instance, embodiments of the deposition rate monitor device may be used for monitoring coating thicknesses or coating rates during evaporation of other than organic materials, such as metals, as well as in CVD processes, PVD processes and sputtering applications. Moreover, embodiments of the deposition rate monitor device may be used in other applications of piezoelectric crystal microbalances such as quartz crystal microbalances, for instance, for microweighing, for measurements of viscosity or viscoelastic properties, and in surface acoustic wave-based sensors.

Further, without limiting the scope, the piezoelectric crystal monitor included in the deposition rate monitor device of embodiments described herein is a quartz crystal monitor (QCM). However, other piezoelectric crystals than quartz may be included in the deposition rate monitor device of embodiments.

Within the following description of the drawings, the same reference numbers refer to the same components. Generally, only the differences with respect to the individual embodiments are described. The deposition rate monitor device of embodiments may also be referred to herein as coating rate monitor device or thin-film thickness monitor device.

The rate of an evaporator, also referred to herein as the coating rate or deposition rate of the vapor produced by the evaporator, depends on the pressure of the evaporated material filling the evaporator tube, e.g. filling the distribution pipe. This pressure corresponds to the vapor pressure of the material. In e.g. linear evaporation sources, a homogeneous deposition rate is achieved by generating in the tube, e.g. in the distribution pipe, a pressure higher than outside of the tube. The pressure difference is correlated to the material flux from the source and therefore to the deposition rate. Higher pressure results in a higher rate. The tube and/or the distribution pipe typically have a high temperature, e.g. up to about 500°C for organic material, to prevent condensation of the evaporated material.

According to an embodiment, a deposition rate monitor device for monitoring the deposition rate of a vapor on a substrate is provided. The deposition rate monitor device includes a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture. In some embodiments, the at least one shielding device is a hollow shield and/or a vapor duct. In further embodiments, at least one of the at least one shielding device is selected from the group consisting of a hollow cylinder and a tubular shield.

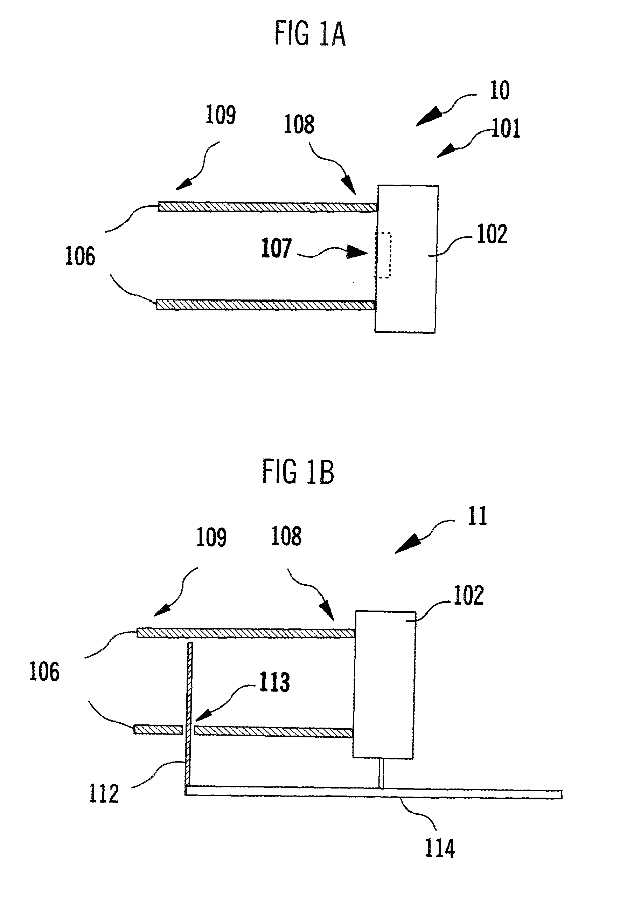

Fig.1A schematically illustrates a deposition rate monitor device 10, also called herein rate monitor device 10, according to one embodiment. The rate monitor device 10 includes as the piezoelectric crystal monitor device a QCM 101 having a housing 102. The QCM 101 may include electrical connections and one or more supplies (not shown), such as a cooling liquid supply and a power supply. The housing 102 has a vapor inlet aperture 107 (indicated in Fig. 1A by a dashed line), which is provided centrally in one sidewall of the housing 102. Further, the deposition rate monitor device 10 includes a tubular shield 106 as the at least one elongated shielding device. The tubular shield 106 has a first end 108 and a second end 109. The first end 108 of the shield 106 is provided at the housing 102 and surrounds the vapor inlet aperture 107. In some embodiments, the shield 106 has an inner diameter of about 10 to 50 mm and a length of about 10 to 100 mm. The shield may include or consist of at least one material selected from the group consisting of stainless steel, Copper and Aluminum.

Embodiments described herein allow for avoiding or preventing piezoelectric crystal signal disturbances arising from adverse influences of the pressure, such as chamber pressure changes, of the temperature, such as temperature variations, and of a moving substrate carrier on a piezoelectric crystal monitor. This is due to the elongated shielding device provided around the vapor inlet aperture of the piezoelectric crystal monitor. Vapor particles arriving at the deposition rate monitor device of embodiments first have to pass the elongated shielding device before entering the housing of the piezoelectric crystal monitor. Therefore, the temperature and the pressure of the vapor arriving at the piezoelectric crystal monitor may be equilibrated before its deposition rate is determined.

In some embodiments, at least one of the at least one shielding devices may be removable from the housing. According to further embodiments, which may be combined with any other embodiment described herein, the deposition rate monitor device includes two shielding devices and one of the shielding devices concentrically encompasses the other one of the shielding devices.

In a further embodiment, which can be combined with any other embodiment described herein, at least one of the at least one shielding devices includes a shutter device adapted to at least partially shut the shielding device. According to one embodiment, the deposition rate monitor device includes two shielding devices and one of the shielding devices concentrically encompasses the other one of the shielding devices. In a modification of the latter embodiment, the inner shielding device may include the shutter device adapted to at least partially shut the shielding device.

Fig. 1B schematically shows as a further embodiment a deposition rate monitor device 11. The rate monitor device 11 differs from the rate monitor device 10 shown in Fig. 1A by further including a shutter device, e.g. near the second end 109 of the tubular shield 106. The shutter device includes a circular shutter 112 which may be pushed or pivoted trough a recess or opening 113 of the tubular shield 106 into the interior space thereof, for at least partially blocking inflow of vapor into the tubular shield 106 and into the QCM 101. In some embodiments, the shutter device includes a manipulator 114, e.g. attached to the housing 102 of the QCM as shown in Fig, 1B, by which the shutter 112 can be inserted in and removed from tubular shield 106. The dimensions of the shutter 112 are adapted to the inner dimensions of the shield 106, in order to at least partially block inflow of vapor into the tubular shield 106. In some embodiments, the shield 106 has a diameter of about 10 to 50 mm and a length of about 10 to 100 mm. Hence, in these embodiments, the part of the shutter 112, which extends into the shield 106, may also have a diameter of about 10 to 50 mm or may at least have a diameter being slightly smaller than the inner diameter of the shield 106. The shutter 112 may include or consist of at least one material selected from the group consisting of stainless steel, Copper and Aluminum.

According to another embodiment, an evaporator for applying vapor to a substrate at a deposition rate is provided, the evaporator including an evaporator tube having a vapor source and a distribution pipe with at least one nozzle outlet, and a deposition rate monitor device according to any of the embodiments described herein.

In some embodiments, the deposition rate monitor device is provided at an opening of the distribution pipe. Further, the vapor source and the deposition rate monitor device may be connectable to a control device adapted for controlling the vapor source depending on the deposition rate. In further embodiments, the evaporator may be provided with a crucible, which contains material to be evaporated and which may be the vapor source. The vapor source may be provided with a heating element for evaporation of material.

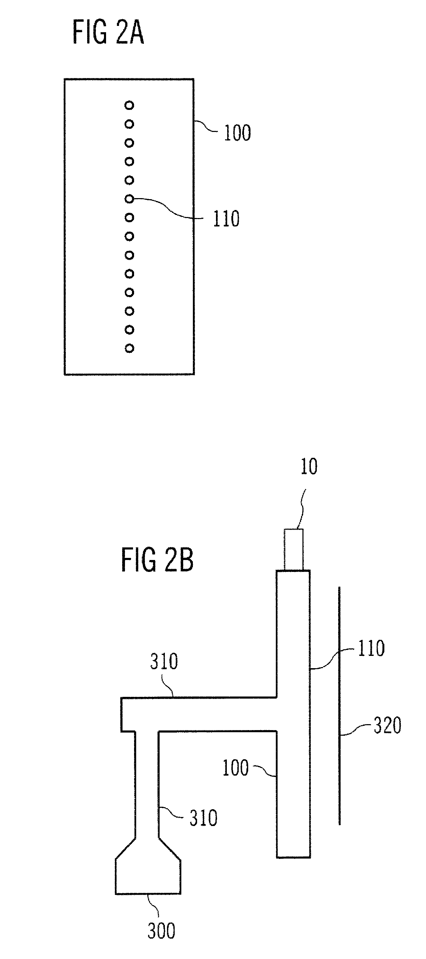

Fig. 2A shows a front view of a distribution pipe 100 of an embodiment of an evaporator of organic material. The distribution pipe 100 of the evaporator includes a multitude of nozzle outlets 110. The diameter of a typical distribution pipe according to embodiments is between 1 cm and 10 cm, more typically between 4 cm and 6 cm. When evaporating a substrate with organic material, the pressure within the distribution pipe, which is larger than the pressure outside, causes the organic vapor to stream out of the distribution pipe towards a substrate (not shown). In the view shown in Fig. 2A, the substrate would be positioned above the paper plane. In typical methods for coating a substrate, the organic vapor is applied to the substrate in a vacuum atmosphere. The term vacuum shall refer to a pressure of 10⁻² mbar and below. Typically, the nozzle outlets are shaped and arranged such that the flow of vapor of one nozzle outlet overlaps with the flow of vapor of a next neighbor nozzle outlet on the substrate surface, in order to optimize the layer uniformity.

Fig. 2B illustrates a side view of the evaporator shown in Fig. 2A. In order to control the coating rate, the organic evaporator according to the embodiment shown in Figs. 2A and 2B includes the deposition rate monitor device 10 shown in Fig 1A. Alternatively, the evaporator may include other herein described embodiments of the deposition rate monitor device. The rate monitor device 10 is in the present embodiment adapted to be coated by the organic vapor provided within the distribution pipe. Therefore, the rate monitor device 10 may be provided at a wall of the distribution pipe, e.g. it may be positioned at or fill an opening of a wall of the distribution pipe.

Generally, the distribution pipe 100 of embodiments can be a hollow body having at least one nozzle outlet 110. The distribution pipe 100 is typically connected with a feeding unit as the vapor source, such as a crucible 300, for feeding the distribution pipe with organic vapor. In the present embodiment the distribution pipe is connected to the crucible via a supply tube 310. Typically, the distribution pipe includes between 15 and 100, typically between 20 and 30 nozzle outlets. The diameter of the nozzle outlets is typically between 0.1 mm and 5 mm, more particular between 1 mm and 2 mm. The distribution pipe can be shaped as tube or the like. In other embodiments, the distribution pipe may be a shower head. If the numbers of nozzles and their respective area of openings are small in comparison to the total size/volume of the distribution pipe, the pipe is considered to be a closed distribution pipe. Then, the pressure within the pipe is more stable and results in better coating processes and deposition rate measurements. Typically, the evaporator tube of embodiments is made of vacuum-compatible material, such as stainless steel.

In some embodiments, the evaporator includes a control device adapted for controlling the vapor source depending on the deposition rate. The vapor source and the deposition rate monitor device may be connected to the control device adapted for controlling the vapor source depending on the deposition rate.

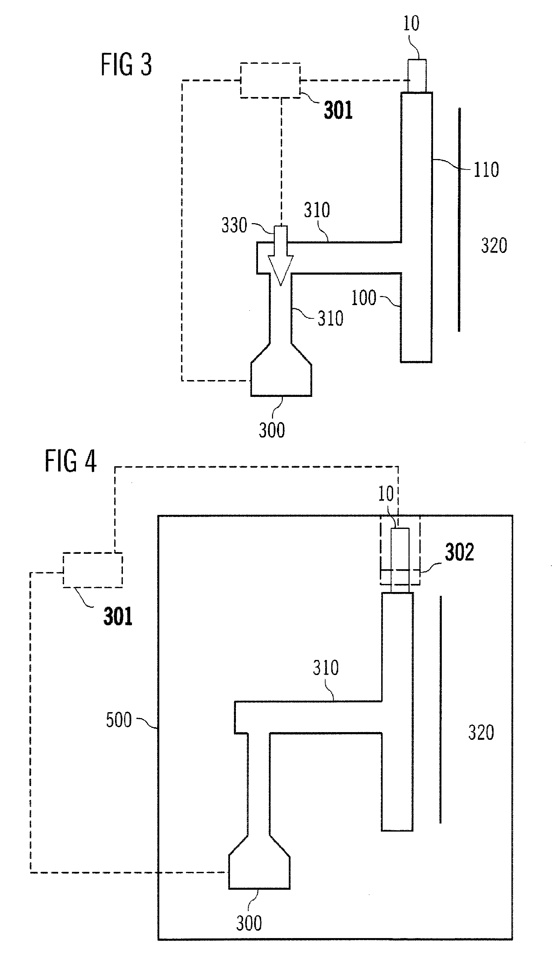

In typical embodiments, the evaporator further includes as the control device an analyzer, also called herein controller or control device 301 (indicated by dashed lines in Fig. 3 and 4), that is linked to the deposition rate monitor device 10, e.g. by a data connection, and which may further be linked to the vapor source 300. The analyzer typically determines the coating rate based on the information supplied by the deposition rate monitor device. Further, typically, the analyzer has access to a memory. Data on typical coating rates of the vapor may be stored on the memory. For instance, the analyzer can include a personal computer, and the memory can be the hard drive of the personal computer or the like. The analyzer may have an input unit, such as a keyboard or a mouse to allow the operator to have influence on the actions of the analyzer and the units connected to the analyzer such as a controllable vapor adjustment means, e.g. a control valve. Further, the analyzer may have an output unit, such as a screen or a plotter, for showing the operator information such as values received from the detector and/or calculation results calculated from these values. The data values measured and the data values stored in the memory may be jointly processed, e.g. compared, in order to determine the actual coating rate.

A gauging step may be performed in a method according to embodiments prior to the application of the vapor to the substrate. Generally, the correlation of the deposition rate and the pressure in the evaporator tube is gauged at the beginning of the coating. A gauging step can be repeated during evaporation e.g. in specific time intervals or constantly. It is also possible that gauging is undertaken during substrate coating. For instance, the coating thickness of the coated substrates can be examined directly after the coating step and be correlated to the deposition rate measured at the time of coating the respective substrate.

A deposition rate control using embodiments described herein is fast, has substantially no dependence on the type of evaporated material. In particular, the deposition rate control using embodiments described herein is a direct deposition rate measurement, which is substantially gas type or vapor type independent. The deposition rate measurement can be performed continuously over days and weeks, which allows a convenient structure and programming of a deposition rate controller.

It is further possible to arrange a vapor adjustment device, such as a control valve, somewhere between the crucible and the distribution pipe of the evaporator. This is exemplarily shown in the embodiment of Fig. 3, where a control valve 330 is positioned between the vertical part of the supply tube 310 and its horizontal part. In the embodiment shown, the crucible is connected to the distribution pipe via the control valve. The control valve 330 is manually or automatically controllable. For instance, the control valve may be completely closed if the deposition of organic material is to be temporarily stopped. In general, it can be controlled in order to control the organic material density within the organic evaporator. That is, the control valve can be used for controlling the coating rate of the organic evaporator. Typically, the control valve can be linked to and be controlled by the analyzer or control device 301 mentioned above. It is also possible that there are more than one control valves installed in the evaporator according to embodiments. For instance, one control valve could be controlled manually, and another control valve could be controlled by the analyzer.

In some embodiments, the organic evaporator includes the crucible 300 and one or more supply tubes 310. The crucible 300 can be filled with the organic material in solid or liquid form. The crucible is then heated to a temperature at which the material partly changes its state of aggregation into vapor.

Typically, the evaporator has a closed geometry. That is, the holes 110 are the only openings for the vapor to exit the organic evaporator. Due to the higher pressure within the organic evaporator in comparison to the pressure in the surrounding atmosphere, the vapor streams out of the distribution pipe onto a substrate 320. Typically, the pressure within the closed geometry of the organic evaporator corresponds to the vapor pressure of the organic material. This pressure is typically in the 10⁻¹ to 10⁻³ mbar range, for instance between about 2 x 10⁻² to 4 x 10⁻² mbar. Thereto in contrast, the pressure outside the organic evaporator may be between about 10⁻⁴ mbar and 10⁻⁷ mbar.

Fig. 4 is a cross sectional side view on an embodiment of a coating installation. Fig. 4 shows the organic evaporator of embodiments within a coating chamber 500 that is typically evacuated by one or more vacuum pumps (not shown) during operation.

Typically, the coating installation according to embodiments includes further process chambers which are positioned before and/or after the organic evaporator. The organic evaporator of embodiments is typically used as a vertical linear organic evaporator. Typically, the substrates are processed inline. That is, the organic material is horizontally evaporated onto a substrate that is vertically oriented. The substrate is typically continuously transported by an assembly line with different process chambers being positioned in a row. In typical embodiments, the time interval needed for coating is in the range of between 10 seconds and 4 minutes, more typically between 30 sec and 90 sec for one substrate. The coating frequency refers to the number of substrates being coated in the time specified.

According to embodiments described herein, the coating installation may include several organic evaporators. The process chambers of the coating installation may have different levels of vacuum. Typically, the substrate to be coated undergoes one or more cleaning process steps before entering the chamber for organic evaporating. It is further typical that the substrate is coated with an inorganic layer after the deposition of one or more organic layers. This is due to the fact that organic materials are sensitive to oxygen. Therefore, a cap layer will protect the organic material layer in many embodiments.

Further, as the organic material can hardly be etched in a wet chemical etching process, it is typical that the substrates are structured with the help of shadow masks during the coating. The shadow mask is typically aligned to the substrate. Typically, a metal mask with a high local precision is aligned in relation to the substrate. The substrate is then coated.

The deposition rate monitor device according to embodiments may include a vapor inlet nozzle, which is adapted to be provided in the vicinity of the second end. In some embodiments the vapor inlet nozzle may be provided within the second end.

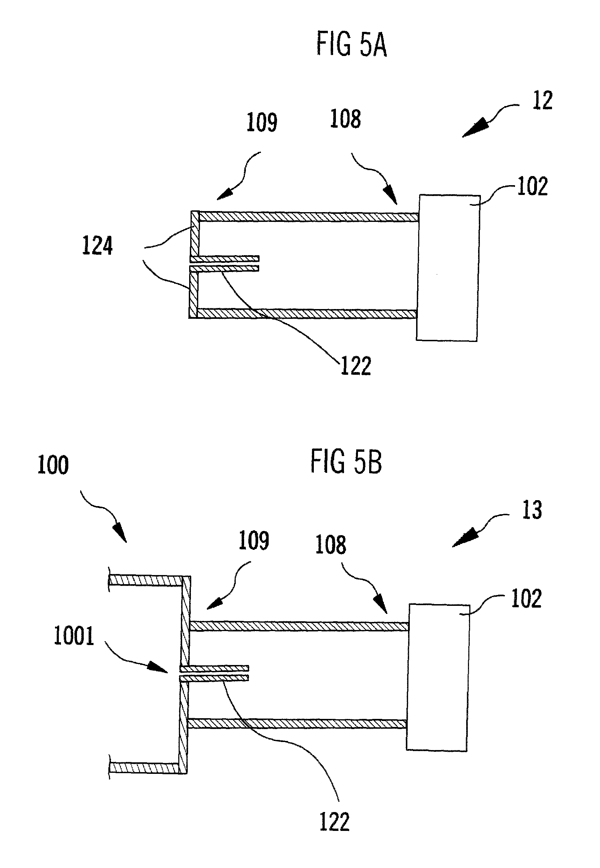

Fig. 5A schematically illustrates as a further embodiment a deposition rate monitor device 12. The rate monitor device 12 differs from the rate monitor device 10 shown in Fig. 1A by having a vapor inlet nozzle 122 provided in a lateral wall 124 closing the second end 109 of the tubular shield 106. The vapor inlet nozzle 122 confines the amount and inlet rate of the vapor particles entering the tubular shield 106 and, hence, entering the QCM 101. The vapor inlet nozzle 122 includes in some embodiments one or more materials selected from the same materials as the whole evaporator. For instance, the vapor inlet nozzle 122 includes at least one material selected from the group consisting of quartz, stainless steel, Copper, and Aluminum. According to some embodiments, which can be combined with any other embodiment described herein, the length of the vapor inlet nozzle 122 is in a range of about 0 to 25 mm and the inner diameter of the vapor inlet nozzle 122 is in a range of about 0.1 to 3 mm.

Fig. 5B shows as an embodiment a deposition rate monitor device 13, in which the vapor inlet nozzle 122 is not provided at the lateral wall 124 of the tubular shield 106, but at an opening 1001 of the lateral wall of the distribution pipe 100 of an evaporator as shown in e.g. Fig. 2B. In other examples, the deposition rate monitor device 13 may be provided at other openings of the evaporator for monitoring the deposition rate of the vapor produced.

In the deposition rate monitor device of embodiments described herein, at least one element selected from the group consisting of the at least one shielding device and the vapor inlet nozzle may have a length and/or an inner dimension, e.g. an inner cross-sectional area, which are adapted to the deposition rate to be monitored. For instance, in either of the embodiments shown in Figs. 1A and 1B, the tubular shield 106 and/or the nozzle 122 may each have dimensions, e.g. a defined length and/or a defined inner diameter, which are adapted to the planned deposition rate and/or to the specifications of the QCM. Thereby, the precision of the deposition rate measurement, and the lifetime of the QCM may be optimized. In some embodiments, the length of the shield 106 may be in a range of about 0.5 to 10 mm, and the length of the nozzle 122 may be in a range of about 0.1 to 3 mm.

In some embodiments of the deposition rate monitor device at least one element selected from the group consisting of the piezoelectric crystal monitor device and at least one of the at least one shielding device is provided on a movable support. Thereby, the piezoelectric crystal monitor device can be moved into an operating position, e.g. to a vapor source, in order to determine the deposition rate of vapor produced. Further, the piezoelectric crystal monitor device can be removed from an operating position e.g. in a coating installation, for exchanging the piezoelectric crystal and for other maintenance procedures. The movable support may include at least one element selected from the group consisting of a sliding guide, a slideway and a bushing.

According to further embodiments, a vapor inlet nozzle is provided at an opening of an evaporator and the movable support is adapted to move at least one element selected from the group consisting of the piezoelectric crystal monitor device and the shielding device towards and away from at least one element selected from the group consisting of the evaporator, an opening of the evaporator, and the vapor inlet nozzle.

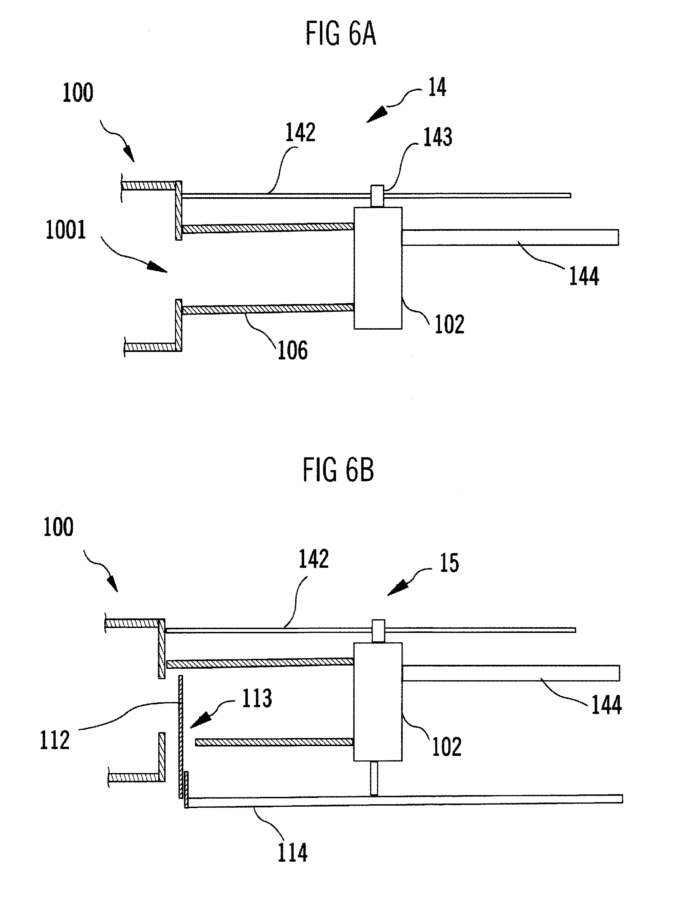

Fig. 6A illustrates schematically as an example of embodiments a deposition rate monitor device 14. The rate monitor device 14 differs from the rate monitor device 10 shown in Fig. 1A by having as a movable support a sliding guide 142 on which a holder 143 of the housing 102 of the QCM 101 is mounted in a slidable manner. In the present example, sliding guide 142 is attached at the lateral wall of distribution pipe 100 of an evaporator, e.g. as shown in Fig. 2B. Sliding guide 142 extends in parallel to the tubular shield 106 such that QCM 101 can be moved in parallel to the tubular shield 106 and towards and away from the opening 1001 of the distribution pipe 100. However, in other examples, sliding guide 142 may be attached to other fixed elements provided in the vicinity of the deposition rate monitor 14, such that the QCM 101 can be moved towards and away from the opening 1001 of the distribution pipe 100. For moving the QCM 101 towards and away from the distribution pipe 100, a manipulator 144 may be provided at the housing 102 of the QCM 101. In Fig. 6A, the rate monitor device 14 is shown being positioned in contact to the distribution pipe 100 and surrounding opening 1001 of the distribution pipe 100, i.e. in an operating position.

Fig. 6B shows as another example of embodiments a deposition rate monitor device 15. The rate monitor device 15 differs from the rate monitor device 14 shown in Fig. 6A by having a shutter device, e.g. as described above referring to Fig. 1B. In the present example, for inserting the shutter 112, the tubular shield 106 includes the recess 113 at the second end 109. In some embodiments, the shutter device includes a manipulator 114, e.g. attached to the housing 102 of the QCM as shown in Fig. 6B, by which the shutter 112 can be inserted in and removed from tubular shield 106. According to the example shown in Fig. 6B, the shutter device can be moved along with the QCM 101. In other examples, only the QCM 101 including the shield 106 can be moved by the movable support, while the shutter 112 is provided in a fixed position.

In some embodiments, e.g. as shown in Fig. 6A and 6B, each of the manipulators 114 and 144 may be adapted to allow manipulation of the deposition rate monitor positioned in a chamber, e.g. a coating chamber, from the outside of the chamber. For instance, when used in a vacuum chamber, the manipulators 114, 144 of the deposition rate monitor and the vacuum chamber may be adapted to each other. In some examples, at least one of the manipulators may have dimensions and bushings or feedthroughs which are vacuum compatible.

In some embodiments, a coating installation for coating substrates is provided, with at least one element selected from the group consisting of a deposition rate monitor device according to any embodiment described herein, an evaporator according to any embodiment described herein, a control device adapted for controlling the vapor source depending on the deposition rate, and a control device adapted for controlling at least one element selected from the group consisting of the evaporator, the deposition rate monitor device, and the vapor source of the evaporator. According to some embodiments, the control device may also control and actuate the shutter device. In some embodiments of a coating installation including an evaporator, a vapor inlet nozzle as described herein is provided at an opening of the evaporator and the movable support of the deposition rate monitor device is adapted to move at least one element selected from the group consisting of the piezoelectric crystal monitor device and the shielding device towards the vapor inlet nozzle and away from the vapor inlet nozzle.

According to some embodiments, the coating chamber includes the evaporator according to any of herein described embodiments and a locking device, such as a lock valve 302 shown in Fig. 4 with dashed lines, adapted for separating the coating chamber and the deposition rate monitor device. Thereby, after removal of the deposition rate monitor device from the operating position inside the coating chamber, e.g. using the movable support of the rate monitor device, it may be even removed from the coating chamber through the lock valve 302, the lock valve may be closed and the deposition rate monitor device 10 and its surroundings may be vented for maintenance procedures.

According to one embodiment, a method for applying vapor to a substrate includes: providing the vapor using at least one element selected from the group consisting of a deposition rate monitor device according to any of herein described embodiments, an evaporator of any of herein described embodiments, and a coating installation according to any of herein described embodiments; determining the deposition rate of the vapor; and applying the vapor to the substrate. The steps of determining and applying may be performed in any sequence.

In some examples of embodiments of the method described herein, the step of determining may be performed continuously or discontinuously.

In further embodiments of the method, which can be combined with any other embodiment described herein, the deposition rate can be adjusted, e.g. by a feedback control. For instance, in some embodiments, the evaporator includes the control device 301 adapted for controlling the vapor source depending on the deposition rate. The vapor source, the deposition rate monitor device, and/or the vapor adjustment means of embodiments of the evaporator described herein may be connected to the control device 301 adapted for controlling the vapor source depending on the deposition rate. For instance, in case a deposition rate exceeding a desired value is determined, the vapor output can be reduced using the vapor source and/or the vapor adjustment means.

Embodiments described herein allow for avoiding or preventing piezoelectric crystal signal disturbances arising from adverse influences of the pressure, such as pressure changes inside of a coating chamber, of the temperature, such as temperature variations, and of a moving substrate carrier on a piezoelectric crystal monitor. This is due to the elongated shielding device provided around the vapor inlet aperture of the piezoelectric crystal monitor and/or due to the additional vapor inlet nozzle of some embodiments. Vapor particles arriving at the deposition rate monitor device of embodiments first have to pass the elongated shielding device and/or the vapor inlet nozzle before entering the housing of the piezoelectric crystal monitor. Therefore, the temperature and the pressure of the vapor arriving at the piezoelectric crystal monitor may be adapted and/or equilibrated before the deposition rate of the vapor is determined. Further, influences of the moving substrate carrier, which can affect the performance of the piezoelectric crystal monitor, may be reduced or even eliminated. The evaporator, the coating installation and the method of embodiments described herein allow for a determination of the deposition rate by a deposition rate monitor device provided at the evaporator. Hence, an optimized feedback control of the deposition rate can be achieved.

According to one embodiment, a deposition rate monitor device for monitoring the deposition rate of a vapor on a substrate is provided, including: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture. The deposition rate monitor device of embodiments can be provided at a device for coating a substrate, an evaporation device, a sputtering device, a CVD device and a PVD device.

According to one embodiment, which can be combined with any other embodiment described herein, the deposition rate monitor device includes a vapor inlet nozzle, which is adapted to be provided in a position selected from the group consisting of in the vicinity of the second end and within the second end.

In one embodiment, which can be combined with any other embodiment described herein, at least one of the at least one shielding device has at least one element selected from the group consisting of a length and an inner dimension which are adapted to the deposition rate to be monitored. The inner dimension may be the diameter of the at least one shielding device.

In one embodiment, which can be combined with any other embodiment described herein, the vapor inlet nozzle has at least one element selected from the group consisting of a length and an inner dimension which are adapted to the deposition rate to be monitored. The inner dimension may be the diameter of the vapour inlet nozzle.

In one embodiment, which can be combined with any other embodiment described herein, at least one of the at least one shielding device is selected from the group consisting of a hollow cylinder, a tubular shield, a hollow shield, and a vapor duct.

In one embodiment, which can be combined with any other embodiment described herein, at least one of the at least one shielding device includes a shutter device adapted to at least partially shut the shielding device.

In one embodiment, which can be combined with any other embodiment described herein, at least one element selected from the group consisting of the piezoelectric crystal monitor device and at least one of the at least one shielding device is provided on a movable support.

In one embodiment, which can be combined with any other embodiment described herein, the movable support includes at least one element selected from the group consisting of a sliding guide, a slideway and a bushing.

In one embodiment, which can be combined with any other embodiment described herein, the deposition rate monitor device includes two of the at least one shielding devices, wherein one of the shielding devices concentrically encompasses the other one of the shielding devices.

In one embodiment, which can be combined with any other embodiment described herein, at least one of the at least one shielding device is removable from the housing.

In one embodiment, an evaporator for applying vapor to a substrate at a deposition rate is provided, the evaporator including: an evaporator tube having a vapor source and a distribution pipe with at least one nozzle outlet, and a deposition rate monitor device which includes: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture.

In one embodiment, which can be combined with any other embodiment described herein, the evaporator includes at least one element selected from the group consisting of the vapor source being controllable, and a controllable vapor adjustment means provided between the vapor source and the distribution pipe.

In one embodiment, which can be combined with any other embodiment described herein, the deposition rate monitor device is provided at an opening of the distribution pipe.

In one embodiment, which can be combined with any other embodiment described herein, the evaporator includes a control device adapted for controlling depending on the deposition rate at least one element selected from the group consisting of the vapor source and the vapor adjustment means.

In one embodiment, which can be combined with any other embodiment described herein, at least one element selected from the group consisting of the vapor source, the vapor adjustment means and the deposition rate monitor device is connectable to the control device adapted for controlling depending on the deposition rate at least one element selected from the group consisting of the vapor source and the vapor adjustment means.

In one embodiment, a coating installation for coating substrates is provided, including at least one element selected from the group consisting of: a deposition rate monitor device including: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture; an evaporator including: an evaporator tube having a vapor source and a distribution pipe with at least one nozzle outlet, and a deposition rate monitor device which includes: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture; a control device adapted for controlling the vapor source depending on the deposition rate; and a control device adapted for controlling at least one element selected from the group consisting of the evaporator, the deposition rate monitor device, and the vapor source.

In one embodiment, which can be combined with any other embodiment described herein, the coating installation includes a vapor inlet nozzle, which is adapted to be provided in a position selected from the group consisting of in the vicinity of the second end of the at least one shielding device and within the second end of the at least one shielding device, wherein at least one element selected from the group consisting of the piezoelectric crystal monitor device and at least one of the at least one shielding device is provided on a movable support, and wherein the vapor inlet nozzle is provided at an opening of the evaporator and the movable support is adapted to move at least one element selected from the group consisting of the piezoelectric crystal monitor device and the shielding device towards and away from at least one element selected from the group consisting of the evaporator, an opening of the evaporator, and the vapor inlet nozzle.

In one embodiment, a coating installation for coating a substrate is provided, including a coating chamber including an evaporator including a deposition rate monitor device with a piezoelectric crystal monitor device, the piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture; and a locking device adapted for separating the coating chamber and the deposition rate monitor device.

In one embodiment, a method for applying vapor to a substrate is provided, including: providing the vapor using at least one element selected from the group consisting of: a deposition rate monitor device including: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture; an evaporator including: an evaporator tube having a vapor source and a distribution pipe with at least one nozzle outlet, and a deposition rate monitor device which includes: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture; and a coating installation including at least one element selected from the group consisting of: the deposition rate monitor device; the evaporator; a control device adapted for controlling the evaporator depending on the deposition rate; and a control device adapted for controlling at least one element selected from the group consisting of the evaporator and the deposition rate monitor device; determining the deposition rate of the vapor, and applying the vapor to the substrate.

In one embodiment, which can be combined with any other embodiment described herein, the deposition rate is determined continuously.

In one embodiment, which can be combined with any other embodiment described herein, the deposition rate is determined discontinuously.

In one embodiment, which can be combined with any other embodiment described herein, the deposition rate is adjusted.

In one embodiment, a method of operating a deposition rate monitor device is provided, the deposition rate monitor device including: a piezoelectric crystal monitor device including a piezoelectric crystal monitor provided in a housing, wherein the housing includes a vapor inlet aperture, and at least one elongated shielding device having a first end and a second end, the first end encompassing the vapor inlet aperture, the method being performed in at least one process selected from the group consisting of coating a substrate, evaporation, sputtering, CVD and PVD.

In one embodiment, which can be combined with any other embodiment described herein, the deposition rate monitor device includes a vapor inlet nozzle, which is adapted to be provided in the vicinity of or within the second end.

In one embodiment, which can be combined with any other embodiment described herein, at least one element selected from the group consisting of the shielding device and the vapor nozzle of the deposition rate monitor device has at least one element selected from the group consisting of a length and an inner dimension which are adapted to the deposition rate to be monitored.

In one embodiment, which can be combined with any other embodiment described herein, the evaporator tube further includes a crucible and a supply tube connecting the crucible and the distribution pipe, the deposition rate monitor device being provided at one element selected from the group consisting of the supply tube and the crucible.

In one embodiment, which can be combined with any other embodiment described herein, the evaporator is an organic evaporator for applying organic vapor to a substrate at a coating rate.

In one embodiment, which can be combined with any other embodiment described herein, the applying of the vapor includes the step of producing the vapor by heating material with the material being provided as a granulate material or as a material wire.

In one embodiment, which can be combined with any other embodiment described herein, the method further includes the step of structuring the substrate by means of a shadow mask.

In one embodiment, which can be combined with any other embodiment described herein, the vapor is an organic vapor, the method optionally further including the step of applying a non-organic cover coating to the substrate.

In one embodiment, which can be combined with any other embodiment described herein, the vapor is provided within the distribution pipe and the pressure of the vapor within the distribution pipe is adjusted between 2x10⁻¹² mbar and 4x10⁻² mbar.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments and embodiments or modifications thereof described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A deposition rate monitor device for monitoring the deposition rate of a vapor on a substrate, comprising:
a piezoelectric crystal monitor device (101) including a piezoelectric crystal monitor provided in a housing (102), wherein the housing includes a vapor inlet aperture (107), and
at least one elongated shielding device (106) having a first end (108) and a second end (109), the first end encompassing the vapor inlet aperture.

2. The deposition rate monitor device of claim 1, comprising a vapor inlet nozzle (122), which is adapted to be provided in the vicinity of or within the second end.

3. The deposition rate monitor device of any of the preceding claims, wherein at least one element selected from the group consisting of the at least one shielding device and the vapor inlet nozzle has a length and/or an inner dimension which are adapted to the deposition rate to be monitored.

4. The deposition rate monitor device of any of the preceding claims, wherein at least one of the at least one shielding device is selected from the group consisting of a hollow cylinder, a tubular shield, a hollow shield and a vapor duct, and/or includes a shutter device adapted to at least partially shut the shielding device.

5. The deposition rate monitor device of any of the preceding claims, wherein at least one element selected from the group consisting of the piezoelectric crystal monitor device and at least one of the at least one shielding device is provided on a movable support (142).

6. The deposition rate monitor device of claim 5, wherein the movable support comprises at least one element selected from the group consisting of a sliding guide, a slideway and a bushing.

7. The deposition rate monitor device of any of the preceding claims, comprising two of the at least one shielding device, wherein one of the shielding devices concentrically encompasses the other one of the shielding devices, and/or wherein at least one of the at least one shielding device is removable from the housing.

8. An evaporator for applying vapor to a substrate at a deposition rate, the evaporator comprising
an evaporator tube (300, 310, 100) having a vapor source (300) and a distribution pipe (100) with at least one nozzle outlet (110), and
a deposition rate monitor device (10; 11; 12; 13; 14; 15) according to any of the preceding claims.

9. The evaporator according to claim 8, wherein the evaporator comprises at least one element selected from the group consisting of the vapor source being controllable, and a controllable vapor adjustment means (330) provided between the vapor source and the distribution pipe; and/or
wherein the deposition rate monitor device (10) is provided at an opening of the distribution pipe (100).

10. The evaporator according to any of the preceding claims, wherein the evaporator includes a control device (301) adapted for controlling depending on the deposition rate at least one element selected from the group consisting of the vapor source and the vapor adjustment means; and/or
wherein at least one element selected from the group consisting of the vapor source, the vapor adjustment means and the deposition rate monitor device is connectable to the control device adapted for controlling depending on the deposition rate at least one element selected from the group consisting of the vapor source and the vapor adjustment means.

11. A coating installation for coating a substrate, comprising at least one element selected from the group consisting of a deposition rate monitor device according to any of claims 1 to 7, an evaporator according to any of claims 8 to 10, a control device adapted for controlling the vapor source depending on the deposition rate, and a control device adapted for controlling at least one element selected from the group consisting of the evaporator, the deposition rate monitor device, and the vapor source.

12. The coating installation of claim 11, wherein the vapor inlet nozzle is provided at an opening of the evaporator and the movable support is adapted to move at least one element selected from the group consisting of the piezoelectric crystal monitor device and the shielding device towards and away from at least one element selected from the group consisting of the evaporator, an opening of the evaporator, and the vapor inlet nozzle.

13. The coating installation of any of claims 11 and 12, comprising a coating chamber including at least one element selected from the group consisting of a deposition rate monitor device according to any of claims 1 to 7 and an evaporator according to any of claims 8 to 10, and further including a locking device adapted for separating the coating chamber and the deposition rate monitor device.

14. A method for applying vapor to a substrate, comprising:
providing the vapor using at least one element selected from the group consisting of a deposition rate monitor device according to any of claims 1 to 7, an evaporator according to any of claims 8 to 10, and a coating installation according to any of claims 11 to 13, determining the deposition rate of the vapor, and
applying the vapor to the substrate.

15. The method according to claim 14, wherein the deposition rate is adjusted.

16. Use of a deposition rate monitor device according to any of claims 1 to 7 in at least one process selected from the group consisting of coating a substrate, evaporation, sputtering, CVD and PVD.
